**Europäisches Patentamt**

**European Patent Office**

**Office européen des brevets**

(11) Veröffentlichungsnummer: **0 107 753**
**B1**

(12) # EUROPÄISCHE PATENTSCHRIFT

(45) Veröffentlichungstag der Patentschrift:
03.05.89

(51) Int. Cl.⁴: **H 05 K 13/04**

(21) Anmeldenummer: **83106904.2**

(22) Anmeldetag: **14.07.83**

(54) Einrichtung zur Halterung einer Leiterplatte.

(30) Priorität: **01.10.82 DE 3236355**

(43) Veröffentlichungstag der Anmeldung:
**09.05.84 Patentblatt 84/19**

(45) Bekanntmachung des Hinweises auf die Patenterteilung:
**03.05.89 Patentblatt 89/18**

(84) Benannte Vertragsstaaten:
**CH DE FR GB LI**

(56) Entgegenhaltungen:
**FR-A- 2 394 960**
**US-A- 3 972 262**
**US-A- 4 170 156**

(73) Patentinhaber: **GRUNDIG E.M.V. Elektro-Mechanische Versuchsanstalt Max Grundig holländ. Stiftung & Co. KG., Kurgartenstrasse 37, D-8510 Fürth/Bay. (DE)**

(72) Erfinder: **Schütte, Wolfgang, Cuxhavener Strasse 50, D-8510 Fürth/Bayern (DE)**

## Beschreibung

Die Erfindung betrifft eine Einrichtung zur Halterung einer Leiterplatte, die mit elektrischen Bauteilen bestückt ist und deren überstehende Drahtenden durch eine Vorrichtung beschnitten werden, die einer im Durchlaufverfahren arbeitenden Lötmaschine zugeordnet ist, wobei die Leiterplatte in einen Lötrahmen eingesetzt ist und während des Durchlaufs durch die Beschneidungsvorrichtung von der Beschneidungsseite her über federnde Druckelemente an einen an der Oberseite der Leiterplatte aufliegenden Niederhalter angedrückt wird und wobei die Druckelemente drehbar sind, entlang der Leiterplatte abrollen können und mit Stiften besetzt sind, die zwischen den überstehenden Anschlußdrähten hindurchgreifen.

Es ist bekannt, daß die Drahtenden von elektrischen Bauteilen, die in bekannter Weise auf Leiterplatten aufgesteckt sind, nach dem Lötvorgang auf eine bestimmte Länge beschnitten werden. Die hierzu erforderliche Beschneidungsvorrichtung, die vorzugsweise mit sogenannten Cutterscheiben arbeitet, ist vorwiegend unmittelbar an einer Lötmaschine angeordnet und beschneidet bereits nach dem Lötvorgang die unterschiedlich überstehenden Drahtenden auf eine vorgegebene Länge. Bei den Leiterplatten üblicher Größe ist der im Durchlaufverfahren angewandte Beschneidungsvorgang ohne wesentliche Schwierigkeiten durchführbar. Nachteilig ist jedoch bei den Beschneidungsvorrichtungen bekannter Art, daß bei der Verwendung von Leiterplatten ab einer bestimmten Breite, so z.B. ab 120 mm Leiterplattenbreite, der Beschneidungsvorgang ungleichmäßig ist, d.h. die Länge der beschnittenen Drahtenden in verschiedenen Flächenbereichen der Leiterplatte ungleich ausfällt. Die nach dem automatischen Beschneidungsvorgang noch ungleich überstehenden Drahtenden der Bauteile bei Leiterplatten geschilderter Größe müssen dann mit großem Aufwand von Hand nachgeschnitten werden.

Aus der US-PS 3 972 262 ist eine Einrichtung zum Beschneiden der Drahtenden von Bauteilen einer bestückten Leiterplatte bekannt, bei der die Leiterplatte durch breite Bürstenrollen mit feststehender Lagerung von der Beschneidungsseite her unterstützt und gegen eine obere Anlage gedrückt wird.

Der Erfindung liegt die Aufgabe zugrunde, eine Einrichtung zur Halterung einer mit elektrischen Bauteilen bestückten Leiterplatte zu schaffen, die gewährleistet, daß die von der Leiterplatte überstehenden Drahtenden durchgehend in gleicher vorgegebener Höhe zu beschneiden sind, wobei die Einrichtung verhindern soll, daß sich die Leiterplatte abhängig von ihrer Größe in Richtung des wirkenden Beschneidungsdruckes durchwölbt. Ferner soll gewährleistet sein, daß die Leiterplatte an eine vorgegebene und einstellbare Anlage mit einem genau vorgegebenen Andruckwert angedrückt wird.

Diese Aufgabe ist bei einer Einrichtung zur Halterung einer Leiterplatte, die mit elektrischen Bauteilen bestückt ist und deren überstehende Drahtenden durch eine Vorrichtung beschnitten werden, gemäß der Erfindung durch die Merkmale des Anspruchs 1 gelöst.

Vorteilhafte Ausgestaltungen der Einrichtung zur Halterung einer Leiterplatte ergeben sich aus den Unteransprüchen.

Die Erfindung wird im folgenden anhand der Zeichnungen näher erläutert. Es zeigt:

Fig. 1 eine schematisch dargestellte Seitenansicht einer Einrichtung zur Halterung einer Leiterplatte gemäß der Erfindung,

Fig. 2 eine schematisch dargestellte Draufsicht der Fig. 1, jedoch bei abgenommener Leiterplatte,

Fig. 3 eine vergrößerte Darstellung eines federnden Druckelementes als Einzelteil aus der Fig. 2 und

Fig. 4 eine Draufsicht der Figur 3.

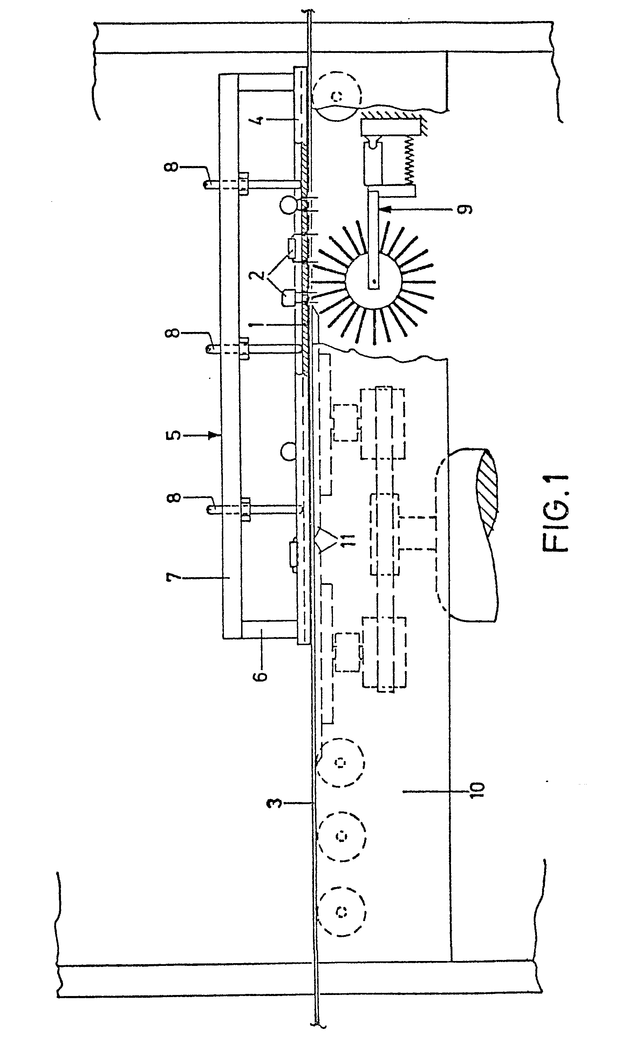

Aus der Figur 1 ist im wesentlichen eine Einrichtung zur Halterung einer Leiterplatte, die mit elektrischen Bauteilen bestückt ist, ersichtlich, wobei die Leiterplatten-Halteeinrichtung einer Beschneidungsvorrichtung, die zum Beschneiden der aus der Leiterplatte überstehenden Bauteil-Anschlußdrähte dient, zugeordnet ist. In der Beschneidungsvorrichtung liegt die Leiterplatte 1, die mit Bauteilen 2 bestückt ist und bereits ein Lötbad einer Lötmaschine durchlaufen hat, auf einem Transportband 3. Hierbei wird die Leiterplatte, wie schon beim Durchlauf durch die Lötmaschine, von einem Lötrahmen 4 umfaßt. Über die Leiterplatte 1 mit Lötrahmen 4 ist ein Niederhalter 5 aufgesetzt, der aus einem Rahmenteil 6 mit Verbindungsstegen 7 besteht. In den Verbindungsstegen sind höhenverstellbare Stifte 8 eingesetzt, die auf der Leiterplatte anliegen und diese auf eine vorgegebene Höhe niederhalten. Unterhalb der Leiterplatte sind mehrere federnde Druckelemente 9 angeordnet, die die Leiterplatte gegen die Stifte des Niederhalters drücken. Das Transportband, dessen Antrieb nicht näher dargestellt ist, wird von einer Auflageschiene 10 getragen.

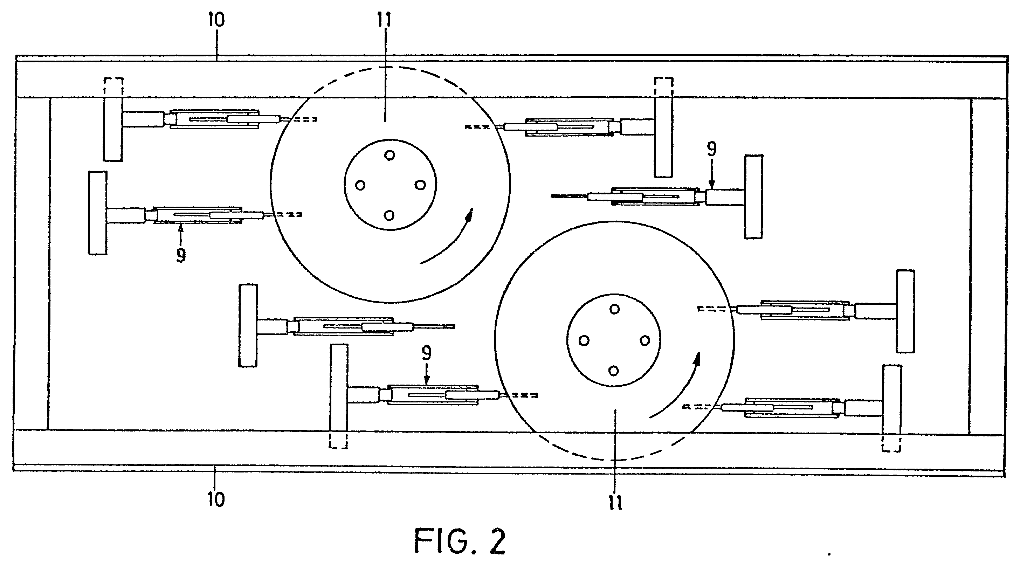

In der Figur 2, die eine Draufsicht der Figur 1 zeigt, ist die flächenmäßige Anordnung der verschiedenen federnden Druckelemente 9 zu erkennen, die unter der Leiterplatte, die über der Beschneidungsvorrichtung geführt ist, angeordnet sind. Zu diesem Zweck ist die Leiterplatte mit aufgesetztem Lötrahmen und Niederhalter nicht gezeichnet. Die Leiterplatte bewegt sich von einer Lötmaschine kommend zur Beschneidungsvorrichtung mittels des Transportbandes entlang den Auflageschienen 10 und wird gemäß der Zeichnung über zwei Cutterscheiben 11 bewegt. Hierbei werden die überstehenden Drahtenden der Bauteile auf eine vorgegebene Länge beschnitten. Die federnden Druckelemente 9 sind über die von der Beschneidungsvorrichtung erfaßte Leiterplattenfläche möglichst gleichmäßig verteilt, wobei der Seitenabstand zueinander ca. 60 mm beträgt. Die federnden Druckelemente suchen sich während des Aufsetzens bzw. der sich bewegenden Leiterplatte laufend freie Anlagestellen an der Lötseite der Leiterplatte und drücken diese an die gegenüberliegenden Stifte des Niederhalters. Um freie Anlagestellen an der Lötseite der Leiterplatte zu finden, müssen die federnden Druckelemente in der Lage sein, den Lötaugen, die sich an den verlöteten Drahtenden der Leiterplatte ergeben, auszuweichen. Hierzu sind die federnden Druckelemente so ausgebildet, daß sie sich sowohl federnd in Richtung der Lötseite der Leiterplatte bewegen als auch seitlich den Lötaugen ausweichen können.

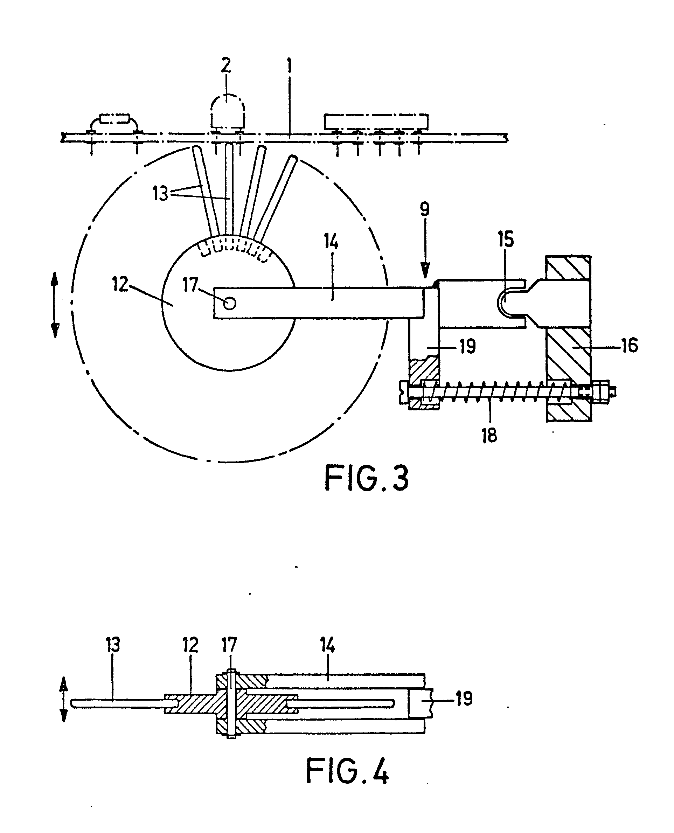

Die Figuren 3 und 4 zeigen eine vergrößerte Darstellung eines federnden Druckelementes 9, wie es in gleicher Ausführung mehrfach zur Halterung der Leiterplatte eingesetzt ist. Das Druckelement 9 besteht im wesentlichen aus einer schmalen Radnabe 12, in die über den äußeren Umfang gleichmäßig verteilt speichenartig nach außen ragende Zylinderstifte 13 eingesetzt sind und einem gabelartig ausgebildeten Hebel 14, der über ein Gelenk 15 auf einem Träger 16 gelagert ist. Die Radnabe 12 ist mittels einer Achse 17 in dem gabelartigen Hebel 14 drehbar gelagert. Die verschiedenen federnden Druckelemente sind weiterhin über den Träger 16 auf einer gemeinsamen nicht näher dargestellten Trägerplatte befestigt. Das Gelenk 15 zwischen dem gabelartigen Hebel 14 und dem Träger 16 ist so ausgebildet, daß sich die Radnabe 12 zur Leiterplatte hin nach oben und unten (s. Pfeil in der Fig. 3) und seitlich (s. Pfeil in der Fig. 4) bewegen kann. Eine Druckfeder 18 mit Begrenzungsstange ist zwischen dem Träger 16 mit Gelenk 15 und einem Ausleger 19 am gabelartigen Hebel 14 eingesetzt und bewirkt den Andruck der Zylinderstifte 13 an die Leiterplatte sowie die Rückstellkraft nach seitlicher Auslenkung des gabelartigen Hebels 14.

## Patentansprüche

1. Einrichtung zur Halterung einer Leiterplatte, die mit elektrischen Bauteilen bestückt ist und deren überstehende Drahtenden durch eine Vorrichtung beschnitten werden, die einer im Durchlaufverfahren arbeitenden Lötmaschine zugeordnet ist, wobei die Leiterplatte in einem Lötrahmen eingesetzt ist und während des Durchlaufs durch die Beschneidungsvorrichtung von der Beschneidungsseite her über Druckelemente an einen an der Oberseite der Leiterplatte aufliegenden Niederhalter angedrückt wird und wobei die Druckelemente drehbar sind, entlang der Leiterplatte abrollen können und mit Stiften besetzt sind, die zwischen den überstehenden Anschlußdrähten hindurchgreifen, dadurch gekennzeichnet, daß jedes Druckelement (9) aus einer schmalen Radnabe (12) mit über den äußeren Umfang in einer Ebene gleichmäßig verteilten, speichenartig eingesetzten Zylinderstiften (13) besteht, daß die Radnabe in einem gabelartig ausgebildeten, senkrecht zur Leiterplatte (1) schwenkbaren und unter Federspannung stehenden Hebel (14) drehbar gelagert ist und daß das Druckelement in einem begrenzten Bereich und gegen eine in Richtung der Ausgangsstellung wirkende Federkraft seitlich ausschwenkbar ist.

2. Einrichtung nach Anspruch 1, dadurch gekennzeichnet, daß mehrere federnde Druckelemente (9) über die von der Beschneidungsvorrichtung erfaßte Leiterplattenfläche möglichst gleichmäßig verteilt sind, wobei der Seitenabstand der federnden Druckelemente (9) zueinander 40 bis 80 mm beträgt.

3. Einrichtung nach den Ansprüchen 1 und 2, dadurch gekennzeichnet, daß der Niederhalter (5) aus einem über der Leiterplatte (1) auf den Lötrahmen (4) aufsetzbaren Rahmenteil (6) mit Verbindungsstegen (7) besteht, in das höhenverstellbare Stifte (8) lagengleich zu den gegenüberliegenden federnden Druckelementen (9) eingesetzt sind.

## Claims

1. Appliance for holding a conductor board which has electrical components mounted on it whose projecting wire ends are cut by a device which is linked to a soldering machine operating on the continuous process basis, the conductor board being inserted in a soldering frame and, while passing through the trimming device is pressed from the trimming side against a hold-down device resting on the top of the conductor board by pressure elements, the pressure elements being capable of rotation and being able to roll along the conductor board and being fitted with pins which reach between the projecting connecting wires, characterized in that each pressure element (9) is composed of a narrow wheel hub (12) with cylindrical pins (13) distributed in one plane uniformly over the outer circumference and inserted in a spoke-like manner, in that the wheel hub is rotatably mounted in a lever (14) of fork-like construction which can swing perpendicularly to the conductor board (1) and is under spring tension, and in that the pressure element can be swung out laterally in a limited region and against a spring force acting in the direction of the starting position.

2. Appliance according to Claim 1, characterized in that several sprung pressure elements (9) are distributed as uniformly as possible over the surface of the conductor board gripped by the trimming device, the lateral distance of the sprung pressure elements (9) from each other being 40 to 80 mm.

3. Appliance according to Claims 1 and 2, characterized in that the hold-down device (5) is composed of a frame part (6) which has connecting bridges (7) which can be placed above the conductor board (1) on the soldering frame (4) and in which pins (8), adjustable in height, are inserted in the same position as the sprung pressure elements (9) situated opposite.

## Revendications

1. Dispositif pour supporter une plaquette à circuits imprimés, qui est équipée de composants électriques et dont les extrémités saillantes des conducteurs sont sectionnées par un dispositif, qui est associé à une soudeuse fonctionnant en continu, et dans lequel la plaquette à circuits imprimés est insérée dans un cadre de soudage et, pendant l'exécution du soudage, est repoussée par le dispositif de sectionnement, à partir du côté de sectionnement, au moyen d'éléments de compression, contre un serre-flan appliqué sur la face supérieure de la plaquette à circuits imprimés, et dans lequel les éléments de compression peuvent pivoter et rouler le long de la plaquette à circuits imprimés et sont pourvus de broches qui s'engagent entre les fils saillants de raccordement, caractérisé en ce que chaque élément de compression (9) est constitué par un petit moyeu de roue (12) comportant des broches cylindriques (13) disposées sous la forme de rayons et réparties uniformément dans un plan sur le pourtour extérieur, que le moyeu de roue est monté de manière à pouvoir tourner dans un levier réalisé en forme de fourche (14), qui peut basculer perpendiculairement à la plaquette à circuits imprimés (1) et est placé sous la contrainte d'un ressort, et que l'élément de compression peut être écarté latéralement par basculement dans une zone limitée et à l'encontre de la force d'un ressort agissant en direction de la position initiale.

2. Dispositif selon la revendication 1, caractérisé en ce que plusieurs éléments de compression élastiques (9) sont répartis d'une manière aussi uniforme que possible sur la surface de la plaquette à circuits imprimés, attaquée par le dispositif de sectionnement, la distance latérale réciproque entre les éléments de compression élastiques (9) étant comprise entre 40 et 80 mm.

3. Dispositif selon l'une des revendications 1 ou 2, caractérisé en ce que le serre-flan (5) est constitué par un élément de cadre (6), qui peut être appliqué par-dessus la plaquette à circuits imprimés (1) sur le cadre de soudage (4) et comporte des barrettes de liaison (7) et dans lequel des broches (8) réglables en hauteur sont insérées dans des positions correspondant à celles des éléments de compression élastique (9) situés en vis-à-vis.

FIG.1

FIG. 2

EP 0 107 753 B1

FIG.3

FIG.4